# EUROPEAN PATENT APPLICATION

(11) **EP 3 346 023 A1**
(43) Date of publication of application: **11.07.2018**
(21) Application number: 17305013.9
(22) Date of filing: 05.01.2017
(51) Int. Cl.: C23C 14/54, G02B 1/115, G02C 7/02

(54) **METHOD FOR LAYER BY LAYER OPTIMIZATION OF A THIN FILM**

(71) Applicant: Essilor International, 94220 Charenton-le-Pont (FR)
(72) Inventor: THORNHILL, David, Farmers Branch, TX 75234 (US)
(74) Representative: Jacobacci Coralis Harle

(57) **Abstract**

Provided herein is a method of coating a substrate is provided. The method includes providing at least one test substrate, b) a programmed physical thickness (T) for at least one layer of the multi-layered coating, and c) a design file comprising a target physical thickness and target spectral performance for the at least one layer of the multi-layered coating; depositing the at least one layer onto the test substrate to form an applied layer having an optical thickness; measuring a spectral performance of the applied layer; and comparing the programmed physical thickness (T) to the optical thickness of the applied layer, thereby generating a data set (ΔT). A system and an optical article produced by the method described herein are also disclosed.

## Description

### RELATED FIELD

The present invention relates to improved thin films and methods of forming said thin films. The improved thin films include those provided as raw materials in a plurality of layers and applied to a surface of a substrate. The improved methods include a means for controlling desired properties of the thin film such as the spectral performance of a thin film.

### BACKGROUND

It is a common practice in the art to prepare coatings for substrates as thin films. Many substrates may be coated on one or several of its surfaces. For example, an optical article such as an ophthalmic substrate may be coated on one or both of its major opposing surfaces. The coatings may include a single coating or a plurality of coatings, many, most or all of which impart to the finished substrate improvements in surface, optical and/or mechanical properties. One such coating for a substrate is an anti-reflective (AR) coating. AR coatings are thin films applied to reduce reflectivity. The AR coating, when complete, typically includes more than one, and up to four or six or more single thin layers that form a so-called "stack." Some of the layers in the stack may be of differing materials, and some of the layers in the stack may be of differing refractive indices. When applied to many substrates, such as polymer substrates, the one or plurality of layers may be arranged on top of a surface coating, often referred to as a hard coating, one that has already been applied to the substrate.

A number of processes and methods have been developed to apply the AR coating (of one or more layers) on the substrate. The substrate, which can include an ophthalmic article, can be a finished or semi-finished substrate (e.g., coated, partially coated, or uncoated). The substrate may be of any type. The substrate may be light transmissive or non-transmissive. For ophthalmic articles, the substrate is a transparent material, such as a glass material, gemstone, or a composite (e.g., polymer). Coatings are then applied on the exposed substrate surface, ensuring that the desired order of the final thin film or stack includes a layer on or closest to the substrate and then outwardly therefrom. One or more layers may be applied to both a rear and front surface of a substrate. For an ophthalmic article, such as a lens, the rear surface is generally the concave surface and, when applied to a lens for a wearer's eye, will be the surface of the substrate closest to a wearer's eye. The front surface for an ophthalmic article, such as a lens, is generally the convex surface and, when applied to a lens for a wearer's eye, will be the surface of the substrate farthest from the wearer's eye.

A conventional process for applying an AR coating (as one or more materials in one or more layers) involves sequentially applying single layers of raw materials onto a substrate in a vacuum chamber, as described further herein. An operator can apply one or more layers sequentially, as needed, to build a desired "stack." The process then further involves sequentially accessing and evaporating at least a portion of the raw materials. Typical raw materials can include, but are not limited to, for example, SiO₂, MgF₂, Al₂O₃, TiO₂, ZrO₂, ITO, Ta₂O₅, and similar materials, or blends of these raw materials that are manufactured by a supplier. The process of evaporation can be done, but is not limited to, using an energetic electron beam, sputter deposition or Joule effect evaporation, to heat one of the raw materials to a sufficient temperature such that at least a portion of the raw material is evaporated, and the evaporated material is then deposited onto the surface of the lens substrate.

The process described herein can be used for other types of multilayer optical films, i.e., films that provide desirable transmission and/or reflection properties at least partially by an arrangement of layers of differing refractive indices. It has been known to make such multilayer optical films by depositing a sequence of inorganic materials in optically thin layers ("microlayers") on a substrate in a vacuum chamber. Inorganic multilayer optical films are described, for example, in H. A. Macleod, Thin-Film Optical Filters, 2nd Ed., Macmilian Publishing Co. (1986) and by A. Thelan, Design of Optical Interference Filters, McGraw-Hill, Inc. (1989).

There are several disadvantages with the above described process. It requires significant operator skill and is prone to operator trial and error adjustment of layers that are deposited onto a lens substrate based on theoretical spectral performance curves of an entire multi-layer coating. An operator may have to make many attempts to determine which deposited layer(s) need to be adjusted in situ (i.e., in real time) to meet the spectral performance requirements of the entire multi-layered coating, thus ensuring that the multi-layer coating will perform as expected, which is both time consuming and wasteful. This is in addition to an operator sometimes being required to carefully manage other parameters of the multi-layer coating, for example, the amount of raw material applied to the substrate, as well as the deposition rate. Because of these limitations the operator may be required to repeat or correct the application of various layers to the substrate in order to achieve the desired outcome for the final multi-layered coating. This process is both hard to control and can have a detrimental effect on product quality and manufacturing efficiency and accuracy. Any of these issues can increase operator time in an already lengthy process, and also introduce unreliability, inconsistency and compromise the quality of each layer and/or the final coating.

There remains a need to improve the efficiency of the AR coating process and the AR coating itself.

### SUMMARY

What is described herein overcomes the problems described above.

In one or more embodiments a method of coating a substrate, including an ophthalmic substrate, is provided. The method includes coating at least one substrate with a multi-layered coating, the method comprising: providing a) at least one test substrate, b) a programmed physical thickness (T) for at least one layer of the multi-layered coating, and c) a design file comprising a target physical thickness and target spectral performance for the at least one layer of the multi-layered coating; depositing the at least one layer onto the test substrate to form an applied layer having an optical thickness; measuring a spectral performance of the applied layer; and comparing the programmed physical thickness (T) to the optical thickness of the applied layer, thereby generating a data set (ΔT).

Also described herein is a system for coating at least one substrate with a multi-layered coating, the system comprising: a vacuum chamber comprising a programmed physical thickness (T); a design file comprising a target spectral performance for at least one layer of the multi-layered coating; and at least one apparatus for depositing at least one layer of the multi-layered coating onto the substrate. The system may be used for applying an AR coating on a substrate, such as an ophthalmic substrate, an optical article, a lens material, and/or a lens article.

An optical article is also presented herein. The optical article is produced by the methods described herein. The methods and systems described herein reduce process steps, operator error, operator interaction, and require a minimum amount of trouble-shooting and skill by an operator. The method and systems described herein can be used for providing a desired coating, such as an AR coating, or any type of multi-layer thin film that changes optical properties as different layers are applied onto a suitable substrate. The methods and systems described herein also reduce the complexity associated with manufacturing AR products.

### BRIEF DESCRIPTION OF THE DRAWINGS

The advantages, nature, and various additional features as described herein will appear more fully upon consideration of the illustrative embodiments now to be described in detail in connection with the accompanying drawings. In the drawings like reference numerals denote similar components throughout the views.
FIG. 1 illustrates a flow chart of the steps in a layer by layer deposition process onto at least one substrate, as described herein;
FIG. 2 illustrates an exemplary vacuum deposition system for deposition of at least one layer onto at least one substrate;
FIG. 3 illustrates the spectral performance (i.e., a plot of the % reflection against various wavelengths) of two substrates after a first and single layer of an AR stack is deposited onto each substrate;
FIG. 4 illustrates the spectral performance (i.e., a plot of the % reflection against various wavelengths) of two substrates after two layers of raw materials are deposited onto each substrate;
FIG. 5 illustrates the spectral performance (i.e., a plot of the % reflection against various wavelengths) of two substrates after three layers of raw materials are deposited onto each substrate;
FIG. 6 illustrates the spectral performance (i.e., a plot of the % reflection against various wavelengths) of two substrates after four layers of raw materials are deposited onto each substrate;
FIG. 7 illustrates the spectral performance (i.e., a plot of the % reflection against various wavelengths) of two substrates after five layers of raw materials are deposited onto each substrate; and
FIG. 8 illustrates the spectral performance (i.e., a plot of the % reflection against various wavelengths) of two substrates after six layers of raw materials are deposited onto each substrate.
FIG. 9 illustrates the spectral performance (i.e., a plot of the % reflection against various wavelengths) of two substrates after seven layers of raw materials are deposited onto each substrate.

### DETAILED DESCRIPTION

The words or terms used herein have their plain, ordinary meaning in the field of this disclosure, except to the extent explicitly and clearly defined in this disclosure or unless the specific context otherwise requires a different meaning.

If there is any conflict in the usages of a word or term in this disclosure and one or more patent(s) or other documents that may be incorporated by reference, the definitions that are consistent with this specification should be adopted.

The indefinite articles "a" or "an" mean one or more than one of the component, part, or step that the article introduces.

Whenever a numerical range of degree or measurement with a lower limit and an upper limit is disclosed, any number and any range falling within the range is also intended to be specifically disclosed. For example, every range of values (in the form "from a to b," or "from about a to about b," or "from about a to b," "from approximately a to b," and any similar expressions, where "a" and "b" represent numerical values of degree or measurement) is to be understood to set forth every number and range encompassed within the broader range of values, and including the values "a" and "b" themselves.

Terms such as "first," "second," "third," etc. may be assigned arbitrarily and are merely intended to differentiate between two or more components, parts, or steps that are otherwise similar or corresponding in nature, structure, function, or action. For example, the words "first" and "second" serve no other purpose and are not part of the name or description of the following name or descriptive terms. The mere use of the term "first" does not require that there be any "second" similar or corresponding component, part, or step. Similarly, the mere use of the word "second" does not require that there be any "first" or "third" similar or corresponding component, part, or step. Further, it is to be understood that the mere use of the term "first" does not require that the element or step be the very first in any sequence, but merely that it is at least one of the elements or steps. Similarly, the mere use of the terms "first" and "second" does not necessarily require any sequence. Accordingly, the mere use of such terms does not exclude intervening elements or steps between the "first" and "second" elements or steps, etc.

As used herein an "anti-reflecting stack" or "AR stack" means a multilayered stack forming an antireflection coating that is deposited on an optical article substrate. As used herein, the "innermost" layer of the anti-reflecting stack means the layer of the multilayered stack which is the closest from the substrate, and conversely the "outermost" layer of the anti-reflecting stack means the layer of the multilayered stack which is the farthest from the substrate.

As used in this application, when an optical article comprises one or more coating(s) on its surface, the phrase "depositing at least one layer or a coating onto at least one substrate" means that a layer or a coating is deposited onto the exposed surface of the substrate external coating (i.e., coating that is the most distant from the substrate). As used herein, a coating or layer that is said to be "on" a substrate or that has been deposited "onto" a substrate is defined as being a coating or layer (i) that is located above the substrate, (ii) that is not necessarily in contact with the substrate, that is to say one or more intermediate coating(s) may be located between the substrate and the coating of interest, and (iii) that does not necessarily totally cover the substrate, although a complete coverage is possible.

As described herein, the outer layer or top layer in a plurality of layers on a substrate is the exposed layer or layers, or layer(s) closest to the layer(s)-air interface. Further, the outer layer or top layer in an assembly as described herein is an outermost layer, or the exposed layer(s), or the layer(s) closest to the layer(s)-air interface when positioned in the assembly or in a receptacle, such as a crucible.

As described herein, the term dielectric means any material that may be a poor conductor of electric current; generally, such materials are electrically insulating. The term is one as would be understood in the relevant field. Generally, a dielectric material as described herein may be selected from a metal oxide, a metal nitride, a metal oxynitride, a polymeric dielectric, or a ceramic. Representative examples include, but are not limited to, SiO, SiO₂, MgF₂, ZrF₄, AlF₃, CaF₃, CeF₃, GdF₃, LaF₃, LiF, Na₃Al₃F₁₄, Na₃AlF₆, TiO, TiO₂, PrTiO₃, LaTiO₃, ZrO₂, Ta₂O₅, Y₂O₃, Ce₂O₃, La₂O₃, Gd₂O₃, Dy₂O₅, Nd₂O₅, HfO₂, Sc₂O₃, Pr₂O₃ Al₂O₃, Si₃N₄, NdF₃, and YF₃. The dielectric material may also comprise a silicon based polymeric dielectric, or an organosilicate.

"Design file" means a file including a datum that describes a thin film or layer of a particular material type to be deposited onto at least one substrate to form an applied layer, as well as a particular order of materials to be deposited. The design file can comprise a target physical thickness (in nm) and/or spectral performance profile for the at least one applied layer. In one aspect the design file can be created using a third party commercially available design software program, such as, e.g., TFCalc, Essential Macleod, OptiLayer, FilmStar, etc). These tools allow a user to build an AR stack using units of physical thickness of the layers or optical thickness. Information in the design file can be used for trouble-shooting the spectral performance of the thin film stack as well as the layer by layer deposition process itself. The design file shows the cumulative data of the spectral profile or performance of each layer, starting with a first layer of a stack, then the effect of a second layer, a third layer, and so on, until the entire stack is represented.

"Physical thickness" of a thin film means the thickness of a thin film, and is typically measured in nanometers (nm).

"Optical thickness" is defined herein to mean the natural logarithm of the ratio of incident to transmitted radiant power through a material, and spectral optical depth or spectral optical thickness is the natural logarithm of the ratio of incident to transmitted spectral radiant power through a material. Optical thickness "O" is also is defined as: O = RI x t (1) where O is the optical thickness, RI is the refractive index of a section of an optical thin film, and t is the actual physical thickness of the section of optical material. Since refractive index is greater than one for normal optical materials, a section of ordinary material typically has an optical thickness that is greater than its corresponding physical thickness. The optical thickness of each layer described herein can be equal to λ/4 at a wavelength of between 280 to 780 nm. "Thin film thickness" means optical thin film thickness.

"Programmed physical thickness" means a predetermined programmed value (i.e., number of units) for physical thickness of a thin film to be deposited onto at least one substrate in a vacuum deposition chamber. The programmed physical thickness is a number of predetermined units, based on material parameters, sufficient to produce a desired physical thickness or optical thickness of a layer or thin film. Programmed physical thickness is intended to mean a physical thickness value that has been programmed in a vacuum deposition chamber.

"Mean reflection factor," noted as Rm, is such as defined in the ISO 13666:1998 Standard, and measured in accordance with the ISO 8980-4 Standard, i.e. this is the (non weighted) spectral reflection average over the whole visible spectrum between 400 and 700 nm. Rm is usually measured for an angle of incidence lower than 17°, typically of 15°, but can be evaluated for any angle of incidence.

"Mean light reflection factor" (also defined as the "visual light reflection factor" or "luminous light reflection factor"), noted as Rv, is such as defined in the ISO 13666:1998 Standard, and measured in accordance with the ISO 8980-4, i.e. this is the weighted spectral reflection average over the whole visible spectrum between 380 and 780 nm. Rv is usually measured for an angle of incidence lower than 17°, typically of 15°, but can be evaluated for any angle of incidence.

The invention described herein allows a user to more efficiently trouble-shoot which layer(s) in a thin film stack may be potentially disrupting an overall spectral performance of an entire multi-layer coating on at least one substrate, such as an ophthalmic lens. Other objects, features and advantages of the present invention will become apparent from the following detailed description. It should be understood, however, that the detailed description and the specific examples, while indicating specific embodiments of the invention, are given by way of illustration, since various changes and modifications within the scope described herein will become apparent to those skilled in the art from this detailed description

Described herein is a method of coating at least one substrate with a multi-layered coating. The method includes providing 1) at least one test substrate; 2) a programmed thickness (T) for at least one layer of the multi-layered coating; 3) a design file comprising a target physical thickness and a target spectral performance for the at least one layer of the multi-layered coating; and 4) at least one raw material for deposition onto at least a portion of the at least one substrate.

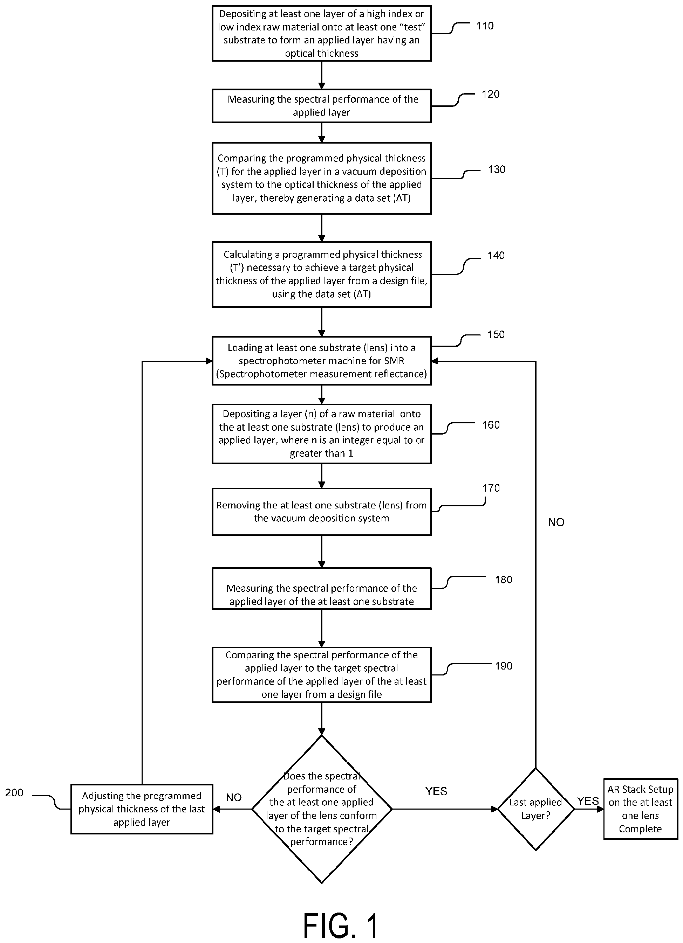

Referring to FIG. 1, the method further comprises 110 depositing the at least one layer of at least one raw material onto at least a portion of the test substrate to form an applied layer having an optical thickness; 120 measuring the spectral performance of the applied layer; and 130 comparing the programmed physical thickness (T) to the optical thickness of the applied layer, thereby generating a data set (ΔT). The method can then include 160 depositing a layer (n) onto a portion of the at least one substrate to form a first applied layer, wherein n is an integer equal to or greater than 1. The at least one substrate can then be 170 removed from the system 29 described herein, and the method can then further comprise 180 measuring the spectral performance of the applied layer of the at least one substrate and 190 comparing the spectral performance of the applied layer to the target spectral performance of the applied layer to the target spectral performance of the applied layer of the at least one layer from a design file. Then the 200 spectral performance of the at least one applied layer of the lens is analyzed to determine whether it conforms to the target spectral performance. If the spectral performance of the at least one applied layer of the lens does not conform to or match the target spectral performance, then 200 the programmed physical thickness of the last applied layer can be adjusted. If the spectral performance of the at least one applied layer of the lens does conform to or match the target spectral performance, and it is the last layer applied to the lens, then the deposition process is complete. If the last layer of the AR stack has not been applied, then the lens can be 150 loaded into spectrophotometer machine and process steps 160 through 190 can be repeated.

The one or more raw materials described herein can be used individually or can comprise at least one layer of a multi-layered stack that has at least one outer or exposed surface. The described methods and systems include removing raw material(s) (all or a portion thereof) from one layer as a first layer for forming a first applied layer or thin film on the substrate, followed by a second layer for forming a second applied layer or thin film on the substrate. This process may be continued until a desired final coating thickness is achieved or until a first stack is delivered in the manner desired. Raw materials described herein may be located in a single vacuum chamber within separate pockets, or on separate sputtering assemblies, or on a multi-faced object that holds different stacks (targets) on its different faces.

If a stack is used, each stack can have at least two independent layers, wherein each layer comprises at least one raw material and at least one outer layer. Each of the at least two independent layers are for sequentially depositing on at least one substrate. Each of the at least two independent layers comprises at least one raw material. The at least one raw material may be a dielectric material such as, but not limited to, SiO₂, MgF₂, Al₂O₃, TiO₂, ZrO₂, ITO, SnO₂, and Ta₂O₅, or mixtures thereof. Each deposited layer may have the same thickness or differing thicknesses. The thickness of each thin film, when deposited on the substrate, is defined by an initial thickness of the layer formed on the pre-fabricated unit or assembly. The thickness of each layer in the assembly is such that, when removed (e.g., evaporated, heated, sputtered, etc.), the final multi-layered coating meets predetermined design criteria, as defined in a design file. In one or more embodiments, the stack of raw material layers are for depositing said raw materials on an optical article, such as an ophthalmic lens. Each raw material layer when deposited forms a thin film on the substrate. A plurality of thin films forms a coating.

The substrate onto which the coating described herein is deposited may be any substrate capable of receiving the materials described herein. In some embodiments, the substrate may be transparent. In some embodiments, the substrate may be an optical article. The substrate may be a lens, such as an ophthalmic lens or lens blank. The term "lens" as used herein generally means an organic or inorganic glass lens, preferably an organic lens, comprising a lens substrate which may be initially coated or partially coated with one or more coatings of various natures.

The optical substrate may be an organic glass substrate comprising, for example, a thermoplastic or a thermosetting material. Thermoplastic materials that may be suitably used for the substrates include (meth)acrylic (co)polymers, especially methyl poly(methacrylate) (PMMA), thio(meth)acrylic (co)polymers, polyvinylbutyral (PVB), polycarbonates (PC), polyurethanes (PU), poly(thiourethanes), polyol allylcarbonate (co)polymers, thermoplastic copolymers of ethylene and vinyl acetate, polyesters such as polyethylene terephtalate (PET) or polybutylene terephtalate (PBT), polyepisulfides, polyepoxides, copolymers of polycarbonates and polyesters, copolymers of cycloolefins such as copolymers of ethylene and norbornene or ethylene and cyclopentadiene, and combinations thereof.

As used herein a "(co)polymer" means a copolymer or a polymer. A (meth)acrylate is an acrylate or a methacrylate. Other exemplary substrates according to the invention include, for example, substrates obtained by polymerizing alkyl(meth)acrylates, especially C₁-C₄ alkyl(meth)acrylates, such as methyl(meth)acrylates such as polyethoxylated bisphenol di(meth)acrylates, allyl derivatives such as aliphatic or aromatic, linear or branched polyol allycarbonates, thio(meth)acrylates, episulfides and precursor mixtures of polythiols and polyisocyanates (for obtaining polythiourethanes).

As used herein a "polycarbonate" (PC) means both the homopolycarbonates and the copolycarbonates and the block copolycarbonates. Suitable examples of polyol allyl carbonate (copolymers include (co)polymers of ethylene glycol bis(allyl carbonate), of diethylene glycol bis 2-methyl carbonate, of diethylene glycol bis(allyl carbonate), of ethylene glycol bis(2-chloro allyl carbonate), of propoyleneglycol bis(2-ethyl allyl carbonate), of 1,3-butenediol bis(allyl carbonate), of 1,4-butenediol bis(2-bromo allyl carbonate), of dipropyleneglycol bis(allyl carbonate), of trimethylene glycol bis(2-ethyl allyl carbonate), of pentamethylene glycol bis(allyl carbonate), of isopropylene bisphenol-A bis(allyl carbonate).

Particularly recommended substrates are those substrates obtained by (co)polymerizing bis allyl carbonate of diethylene glycol, marketed, for example, under the trade name CR-39® by PPG Industries (Essilor ORMA® lenses). The particularly recommended substrates also include those substrates obtained by polymerizing thio(meth)acrylic monomers, such as those described in the French patent application FR 2734827. The substrates may be obtained by polymerizing mixtures of the hereinabove mentioned monomers, or they also may comprise mixtures of such polymers and (co)polymers. Exemplary substrates are those made of a crosslinked material (thermosetting material); especially allylic, (meth)acrylate type, thio(meth)acrylate type or poly(thio)urethane substrates.

Each thin film or layer may be applied to one or more primary faces of a substrate, including a front side (convex surface), a back side (concave surface), edges, and any combination thereof. As also used herein, the "rear face" (typically concave) of the substrate means the face which, in the final article, is located the nearest to the user's eye. "Front face" (typically convex) of the substrate means the face which, in the final article, is the most distant from the user's eye.

The AR stack of the present invention may include any layer or stack of layers which improves the anti-reflective properties of the finished optical article over at least one portion of the visible spectrum, thereby increasing the transmission of light and reducing surface reflectance. The dielectric layers of the multilayer anti-reflecting coating are deposited on the optical surface in the reverse order they should be present on the finished optical article. The total number of layers deposited onto the substrate to form a multi-layered antireflective (AR) coating can typically be from 2 to 9 layers.

The step of depositing at least one layer onto the at least one substrate further comprises depositing the at least one layer or coating to form the multilayered antireflective coating, wherein the at least one layer consists of alternating high index (HI) and low index (LI) materials, i.e., a HI material having a high refractive index (RI) or a LI material with a low refractive index. In one embodiment the multi-layered coating comprises at least two layers with a low refractive index and at least two layers with a high refractive index.

A "layer" of the antireflective coating is said to be a layer with a high refractive index when its refractive index is higher than or equal to 1.6, preferably higher than or equal to 1.7, even more preferably higher than or equal to 1.8 and most preferably higher than or equal to 1.9 and lower than 2.1. A layer of an antireflective coating is said to be a low refractive index layer when its refractive index is lower than 1.55, preferably lower than or equal to 1.48, and more preferably lower than or equal to 1.47. Unless otherwise specified, the refractive indexes referred to in the present application are expressed at 25 °C, at atmospheric pressure and at a wavelength of 550 nm.

High index layers can comprise one or more metal oxides such as, without limitation, ZrO₂, TiO₂, Al₂O₃, Ta₂O₅, Si₃N₄, Nd₂O₅, Pr₂O₃, PrTiO₃, La₂O₃, Nb₂O₅, Y₂O₃, Ce₂O₃, Dy₂O₅, HfO₂, Ss₂O₃, and mixtures thereof. Low index layers may comprise, without limitation, SiO₂, MgF₂, ZrF₄, AlF₃, Na₃Al₃F₁₄, Na₃AlF₆, and mixtures thereof.

Each layer of the AR multi-layer coating is defined as having a thickness higher than or equal to 1 nm. Each layer of the AR stack may be of the same thickness or of differing thickness. Generally, HI layers and LI layers, other than the innermost and outermost layers of an AR stack, can have a physical thickness, ranging respectively, from 10 to 160 nm (HI) and 10 to 120 nm (LI). The multi-layer coating total thickness can be about 500 nm to about 1.5 µm. Actually obtained physical thickness values may be different from programmed physical thickness values. A top coat is then applied. The top coat can be hydrophobic or hydrophilic. The top coat can be a DSX-based anti-fouling coat which can be deposited onto the at least one substrate after the high index and low index optical material layers are deposited. The resulting multi-layer coating or layer can have, for example, a programmed thickness of 14 nm.

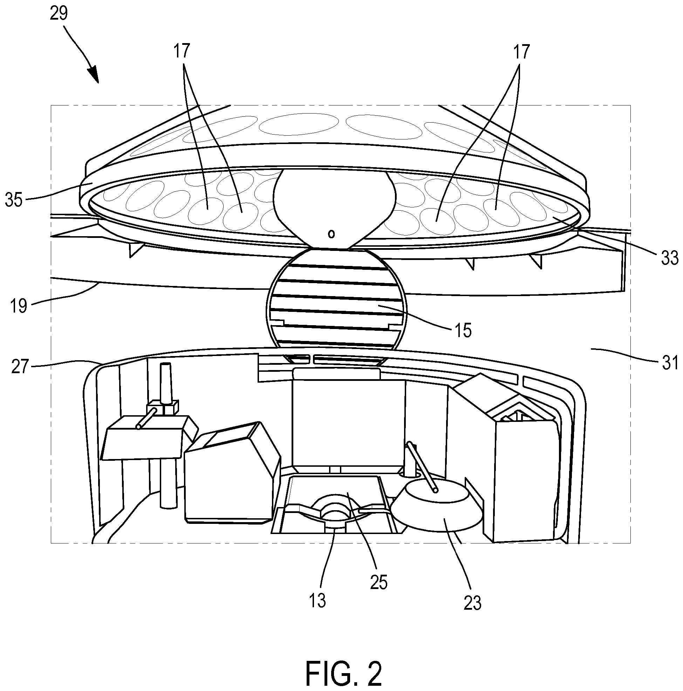

Referring to FIG. 2, described herein is a system 29 for the deposition of the at least one layer onto the at least one substrate. The substrate surface before coating can comprise an uncoated, unfinished, semi-finished, or a finished surface. Exemplary methods for coating the substrate include, but are not limited to, evaporation with or without ion beam-assistance, ion beam sputter, sputter deposition (e.g., cathode, RF, reactive, ion beam sputter, gas flow or magnetron sputtering), plasma-assisted vapor-phase chemical deposition, and spin coating. a vacuum chamber comprising a programmed physical thickness (T); a design file comprising a target spectral performance for at least one layer of the multi-layered coating; and at least one apparatus for depositing at least one layer of the multi-layered coating onto the substrate, wherein the apparatus is configured to deposit the at least one layer onto the substrate to form an applied layer having an optical thickness., wherein the apparatus is configured to deposit the at least one layer onto the substrate to form an applied layer having an optical thickness; and at least one optical monitoring apparatus.

The coating, when formed on the at least one substrate can be a thin film coating, an anti-reflection (AR) coating (i.e., Crizal® AR coating), a reflection (mirror) coating, a beamsplitter coating, a filter coating (e.g., bandpass filter, dichroic filter, neutral density filter, longpass filter, and shortpass filter coatings) (collectively "coatings").

Substrates may be coated singly, or a plurality of substrates may be simultaneously coated. To achieve substantially equal thickness of a deposited thin layer on the one or more substrates, such as an optical lens, substrates are positioned in a chamber, and one or more, and often several, or all of the following may be used in combination: rotating the substrate(s) around a central axis and use of a uniformity mask positioned between an energy source and the substrate(s). Placement of the energy source relative to the substrate(s), the mounting of substrate(s) into a support for holding the substrate(s) in place, and how and where the pre-fabricated stack (or stacks, with or without a receptacle) is positioned with respect to the energy source can also be modified to ensure coating uniformity.

The system 29 comprises a vacuum chamber 31 having an upper region 19 and a lower region 27 and a vacuum port 15. Any suitable vacuum chamber system known to those of skill in the art may be suitable for use. Representative machines include the Satisloh® MC 380 coating system (registered with Satisloh AG, Switzerland), Balzers BAK-600 evaporator system, Leybold 1104 machine fitted with an electron gun ESV14 (8 kV), or Satis 1200 DLX coating system.

The system 29 includes a programmed physical thickness (T) and a target spectral performance for at least one layer of the multi-layered coating; a design file comprising a target spectral performance for at least one layer of the multi-layered coating; at least one apparatus for depositing at least one layer of the multi-layered coating onto the substrate, wherein the apparatus is configured to deposit the at least one layer onto the substrate to form an applied layer having an optical thickness; and at least one optical monitoring apparatus. The monitoring apparatus disclosed herein may include means for automatically or manually monitoring and controlling the rate of deposition, the thickness of one or more thin films when deposited, and the spectral performance of each layer. The optical monitoring apparatus can control the thickness of each applied layer. Alternatively, instead of an optical monitoring device, the system 29 may comprise a quartz-crystal monitor, described herein, which is also capable of monitoring the thickness of an applied layer. The system 29 can also include a means for monitoring the conformance of the spectral performance of at least one layer of the multi-layered coating to the target spectral performance of the at least one layer of the multi-layered coating. The means for monitoring such conformance can be a software program.

The system 29 includes an energy source 25 operably positioned within chamber 31. To deposit the at least one layer onto the substrate, a sufficient amount of continuous or non-continuous energy is automatically or manually delivered to at least a portion of a supplied raw material source from an exposed layer deposited onto a desired surface of the substrate. The method described herein forms the multi-layered coating on the at least one substrate. The at least one substrate may be an ophthalmic lens substrate.

A vacuum may be created in the chamber 31 using at least one vacuum pump (not shown), which is operably coupled with chamber 31. Energy source 25 can be an emitter, such as an e-beam source (e.g., e-beam gun, and can be for thermionic emission, or with a cathodic arc, as examples, with or without an ion beam assist). In one or more embodiments, the energy source 25 is a magnetron sputter source. An AR stack may be disposed between a receptacle 13 and a substrate 17. In some embodiments, a shutter 23 may be arranged to selectively cover at least a portion of the source 25 and/or the AR stack. Shutter 23 may be moveable, operable in a closed position or an open position.

In some embodiments, the source 25 is positioned in the lower region 27 of the chamber 31. The source 25 may further comprise component(s) that are configured and/or arranged for providing a supply of electrons for evaporation of the one or more of the raw materials contained in each of the two or more layers contained in the AR stack.

For applications that include an e-beam source, a power level of the e-beam source will be governed by the raw material evaporation temperature. Power supplies for an e-beam source may range from about 4 kV to about 6 kV, or from 5 kV to about 8 kV, which is suitable for most dielectric materials, or may provide a power up to 10 kV or more, which may be necessary or useful with very high rates of deposition, or with use of additional materials, such as thermally conductive materials (e.g., in a large chamber). A beam sweep assembly and controller (not shown) may also be included, which can assist with consistent distribution of the layers. An e-beam as a source 25 is useful in many embodiments because many raw materials (e.g., dielectrics) described herein, including raw materials commonly used for visible and near infrared coatings, cannot be deposited by purely thermal means and require enough energy (e.g., power) for removal of the raw material(s) from the two or more layers. In one or more embodiments, such as for optical applications, the amount of energy delivered may be in an amount or in a range between about 150 W and 1000 W. It may also be between about 200 W and 850 W, or between about 250 W and 800 W, or between about 270 W and 780 W. Energy that is emitted (e.g., thermally emitted energy) from the energy source may be directed by a focusing unit. In one embodiment, the energy acts on at least a portion of each layer sequentially, by melting, evaporating or sublimating at least a portion of the raw material(s) forming said one layer, then continuing with the next layer, beginning with the region at the top that is exposed.

The vacuum chamber device 29 may also comprise at least one support 33 for receiving one or any number of substrates. The support(s) 33 are housed in a rotating dome 35. The one or more substrates may be rotated with respect to a central point of the chamber or with respect to a central axis of the rotating dome 35, in order to obtain coating uniformity.

The rate of the evaporation may be affected by the raw material itself. The rate of evaporation, deposition, and thin film or total coating thickness may be controlled by a monitoring system such as a quartz-crystal monitoring (QCM) system, or alternatively, an optical monitoring system (not shown).

Optical monitoring systems can include a separate monitor chip, which allows for the possibility of a discrepancy between the chip and the substrate. Some optical monitoring software contains provisions for choosing reflection or transmission modes, as well as allowing for selection of a wide range of monitoring wavelengths. An optical monitoring system may produce spectral data within targeted wavelength ranges, for example, in visible range, UV range, or other ranges. An optical monitoring system may be contained partially within the vacuum chamber and partially outside. For example, within the chamber may be the crystal, a sensor head (with the electrical connections, water lines, thermocouples and/or heating elements) and feedthrough (e.g., connections between one or more internal components inside and ones outside the chamber). The external items to the chamber may be components, such as cables and fittings from the feedthrough, an oscillator (for crystal vibration) and its accessory/measuring components, a display, and a controller.

QCM systems can have a high accuracy (± 2%), often measurable in Angstroms. These systems can help maintain the deposition rate and the thickness of the layers via a proportional integral derivative (PID) loop by adjusting the input and output parameters of a feedback loop. The vacuum chamber system 29 may be coupled with a controller (not shown) that uses the feedback circuit to adjust the power of the source based on film deposition rate information fed to it via the QCM or optical thin film thickness monitors. The desired rise and soak parameters as well as the deposition rate or final physical thickness of a thin film may be entered into the process controller prior to film deposition. The process controller may be responsible for starting the deposition process, maintaining all necessary parameters regarding the source during deposition itself, and stopping the deposition once a desired thin film physical thickness or total coating thickness on the substrate is reached. While the QCM and optical monitoring systems may not allow a user to make corrections after evaporation has taken place, and does not allow for on-the-spot corrections, or to stop the evaporation process, in one or more embodiments, the improved methods and systems described herein do allow for real-time corrections.

The system 29 may optionally include a spectrophotometer for measuring the spectral performance of an optical article. More particularly, the spectral performance can be measured using custom-made or commercially available spectrophotometers such as, but not limited to, a Perkin-Elmer Lambda 850 with an URA accessory (Universal Reflectance Accessory).

The systems described herein may be used together with hardware and associated software known in the art and a Windows^{®} based graphical user interface, for example. A single instrument can interface with the control software to substantially control substantially the entire chamber evaporation system. The software may be programmed to have broad band monitoring capabilities, including monitoring, and/or allowing real-time evaluation of the evaporation rate and the deposition rate or formation of the thin film.

After the step of depositing the at least one layer of the stack on to the at least one substrate, the method of coating the at least one substrate further includes 140 calculating, using the data set (ΔT) described above, a programmed physical thickness (T') sufficient to achieve the target physical thickness for the at least one applied layer. The method further includes 150 loading at least one substrate (lens) into a spectrophotometer machine for SMR (spectrophotometer measurement reflectance). The method further includes measuring a spectral performance of the applied layer using a spectrophotometer. The method of 120/180 measuring the spectral performance includes measuring the reflection spectrum of the applied layer. The method further includes comparing the spectral performance of the applied layer to the target spectral performance of the at least one layer and adjusting the programmed thickness of the applied layer such that it is substantially equal to the target spectral performance of the at least one layer.

### Example 1

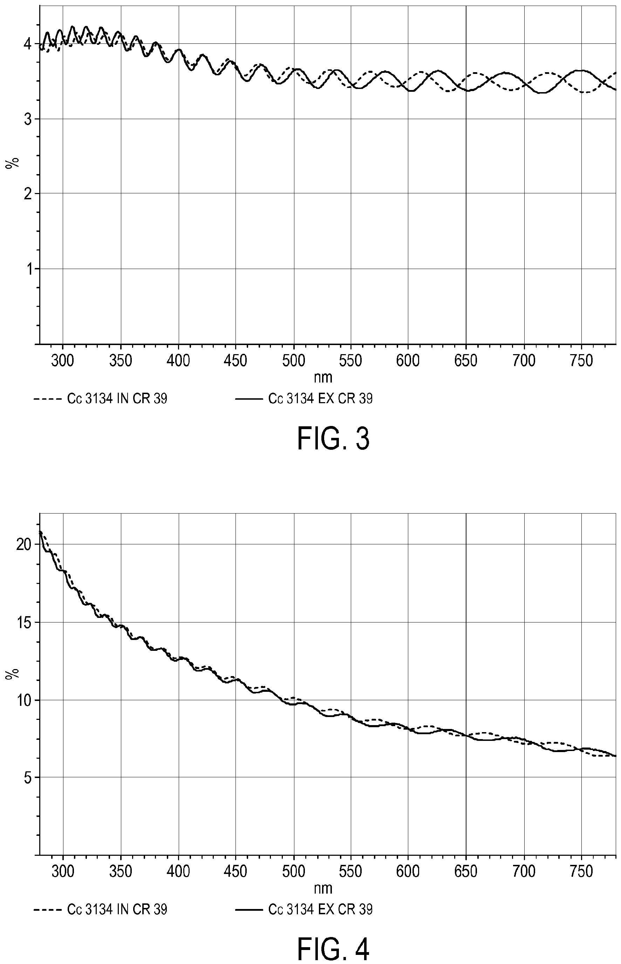

Referring to FIG. 3, a graph of the spectral performance (i.e., a plot of the % reflectance against various wavelengths) after the deposition of a single raw material layer onto at least one substrate is illustrated, using the methods and systems described above. Below in Table 1 is data corresponding to the spectral performance of FIG. 3.

**Table 1**

| Identification Face | h(°) (hue angle h) (at a 15° angle of incidence) | C* (chroma) | Rm (%) (400-700 nm) (mean reflection factor) | Rv (%) (380-780 nm) (Visible light reflectance) |
|---|---|---|---|---|
| Cc ORMA (Interior) | 278* | 0.8* | 3.56* | 3.53* |
| Cc ORMA (Exterior) | 281* | 0.7* | 3.56* | 3.52* |
| Mean | 280 | 0.8 | 3.56 | 3.52 |

Table 1 describes the hue, chroma, Rm% (400-700 nm), and Rv% (380-780 nm) after the deposition of a first layer "n" of a raw material onto at least one substrate, where the substrate is a lens. The raw material is a high index material. More particularly, the lens substrate is an ORMA lens. In this example, a first and single layer of a high index material was deposited onto at least a portion of the identification face or concave (Cc) surface of the lens. More particularly the high index layer HI-1 was deposited onto each of two lenses that were positioned within a vacuum deposition chamber. One lens was positioned in an interior (IN) position and another lens was positioned in an exterior (EX) position of the vacuum chamber. This positioning of the lens substrates allowed the high index layer HI-1 to be deposited in a substantially even distribution across the concave surfaces of each of the lenses to form an applied layer of the high index raw material HI-1. HI-1 can be any high index material, such as those described above.

The high index layer HI-1 was deposited onto at least a portion of the concave surface of each of the lenses such that the mean hue angle (h) of the at least one applied layer was 280 ± 3. After the spectral performance of the at least one applied layer comprising a high index layer HI-1 was measured using a spectrophotometer, the programmed physical thickness (T) of the at least one applied layer was compared to the optical thickness of the applied layer, thereby generating a data set (ΔT). In each example described herein the spectral performance and numeric values measured for each layer were compared to that of the design file to determine conformance or non-conformance with the design file. The mean chroma was 0.8 ± 3% at a 15 degree angle of incidence. The mean reflection factor, Rm, on the rear face or concave face of the lens, between 400 and 700 nm, was 3.56% ± 3%. The mean light reflection factor, Rv, on the rear face or concave face of the lens in the visible region Rv was 3.52% ± 3%. As indicated by the asterisk, the hue angle (h), chroma C*, Rm (400-700 nm) and Rv of the high index layer HI-1 did not conform to the values associated with the programmed physical thickness value T or any of the parameters associated with the design file, such as, for example, spectral performance.

In each example described herein the method can further comprise adjusting the programmed physical thickness (T) of the applied layer and further depositing at least one layer n onto the at least one substrate, where n is an integer equal to or greater than 1. The programmed physical thickness can be adjusted if the spectral performance or other characteristics of the applied layer do not conform to the target spectral performance. This deposition process can be repeated for each layer "n" of raw material from an AR stack that is deposited onto the at least one substrate.

### Example 2

Referring to FIG. 4, a graph of the spectral performance (i.e., a plot of the % reflectance against various wavelengths) after the deposition of a single raw material layer onto at least one substrate is illustrated, using the methods and systems described above. Below in Table 1 is data corresponding to the spectral performance of FIG. 4.

**Table 2**

| Identification Face | h (°) (hue angle h) | C* (chroma) | Rm (%) (400-700 nm) (mean reflection factor) | Rv (%) (380-780 nm) (Visible light reflectance) |
|---|---|---|---|---|
| Cc ORMA (IN) | 265* | 6.7 | 9.36* | 8.92* |
| Cc ORMA (EX) | 265* | 6.7 | 9.23* | 8.77* |
| Mean | 265 | 6.7 | 9.29 | 8.84 |

Table 2 describes the hue, chroma, Rm% (400-700 nm), and Rv% (380-780 nm) after the deposition of a high index layer HI-1, followed by a low index layer LI-1 of raw material, onto at least one substrate, where the substrate is a lens. The HI-1 and LI-1 layers can be selected from any of the high index or low index layer materials described herein. More particularly, the lens substrate is an ORMA lens. The high index layer HI-1, followed by a second low index layer LI-1, was deposited onto at least a portion of the identification face or concave (Cc) surface of each lens substrate. In this example two lenses were positioned within a vacuum deposition chamber, one lens in an interior (IN) position and another lens in an exterior (EX) position. This positioning of each lens substrate allowed the high index layer HI-1 and the second low index layer LI-1 to be deposited in a substantially even distribution across the concave surfaces of each of the lenses to form applied layers of a high index layer HI-1 and low-index layer LI-1.

The layers HI-1 and LI-1 were deposited onto at least a portion of the concave surface of each of the lenses such that the cumulative mean hue angle (h) of the applied layers HI-1 + LI-1 was 265 ± 3. After the spectral performance of the layers HI-1 + LI-1 was measured using a spectrophotometer, the programmed physical thickness (T) of the applied layers HI-1 + LI-1 was compared to the optical thickness of the applied layers, thereby generating a data set (ΔT). In each example described herein the spectral performance and numeric values measured for each layer were compared to that of the design file to determine conformance or non-conformance with the design file.

As indicated by the asterisk, the hue angle (h), Rm (400-700 nm), and Rv (380-780 nm) of the applied layers HI-1 + LI-1 did not conform to the values associated with the programmed physical thickness value T or any of the parameters associated with the design file, such as, for example spectral performance. In this example the mean chroma was 6.7 ± 3 at an angle of incidence of 15°. The mean reflection factor, Rm, on the rear face or concave face of the lens, between 400 and 700 nm, was 9.29% ± 3%.

As each layer of high index (HI-1) raw material and low index (LI-1) raw material was deposited onto the at least one substrate, each cumulative layer could be compared to the spectral performance data of each layer in the design file to see if the spectral performance matched the design file. If the actual spectral performance of each layer was different from the theoretical spectral performance at any time during the deposition of the different layers, then it was known in real time which layer to adjust before proceeding to the deposition of the next layer. This allows a user to trouble-shoot a thin film stack by depositing and evaluating each layer, in a cumulative fashion, starting with the first layer and comparing it against the spectral performance data for each layer in the cumulative evolution in the design file.

### Example 3

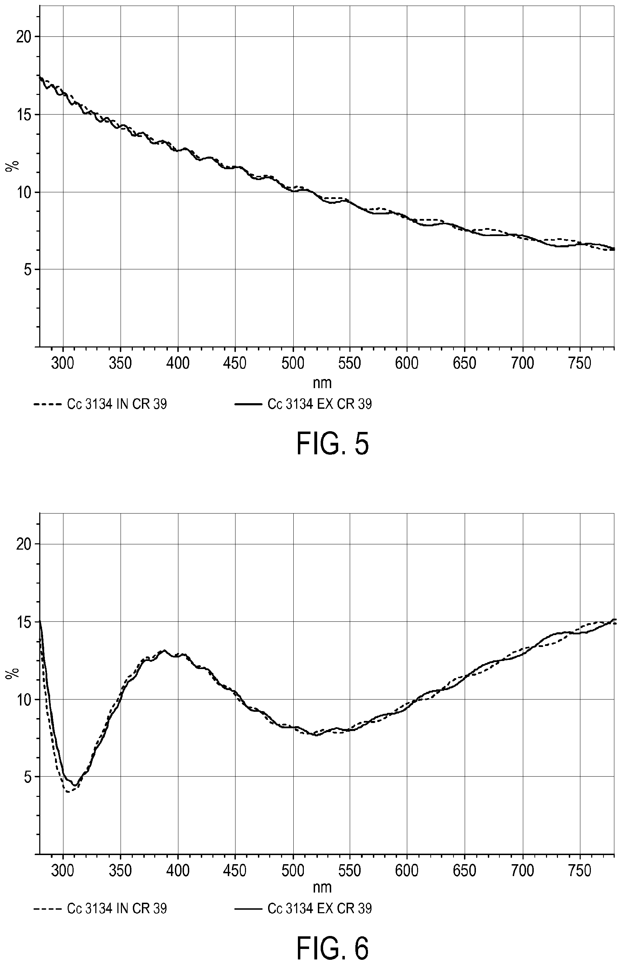

Referring to FIG. 5, a graph of the spectral performance (i.e., a plot of the % reflectance against various wavelengths) after the deposition of a single raw material layer onto at least one substrate is illustrated, using the methods and systems described above. Below in Table 1 is data corresponding to the spectral performance of FIG. 5.

**Table 3**

| Identification Face | h(°) (hue angle h) | C* (chroma) | Rm (%) (400-700 nm) (mean reflection factor) | Rv (%) (380-780 nm) (Visible light reflectance) |
|---|---|---|---|---|
| Cc ORMA (IN) | 258* | 6.7 | 9.52* | 9.20* |
| Cc ORMA (EX) | 259* | 6.8 | 9.41* | 9.06* |
| Mean | 259 | 6.8 | 9.46 | 9.13 |

Table 3 describes the hue, chroma, Rm% (400-700 nm), and Rv% (380-780 nm) after the deposition of three layers of raw materials. The layers comprise a first layer of a high index (HI-1) material + a second layer of a low index (LI-1) material + a third high layer of a index (HI-2) material, onto at least one substrate, where the substrate is a lens. Each of the layers HI-1 and HI-2 can be chosen from any of the high index materials described herein. The LI-1 layer can be chosen from any of the low index materials described herein. More particularly, the lens substrate is an ORMA lens. Each of the three layers was deposited onto at least a portion of the identification face or concave (Cc) surface of the lens. In this example at least two lenses were positioned within a vacuum deposition chamber, one lens in an interior (IN) position and another lens in an exterior (EX) position. This positioning of each lens substrate allowed the layers HI-1, LI-1, and HI-2 to be deposited in a substantially even distribution across the concave surfaces of each of the lenses to form applied layers of HI-1, LI-1, and HI-2.

The layers HI-1, LI-1, and HI-2 were deposited onto at least a portion of the concave surface of each of the lenses such that the cumulative mean hue angle (h) of the applied layers HI-1, LI-1, and HI-2 was 259 ± 3. After the spectral performance of the applied layers comprising HI-1, LI-1, and HI-2 was measured using a spectrophotometer, the programmed physical thickness (T) of the applied layers HI-1, LI-1, and HI-2 was compared to the optical thickness of the applied layers, thereby generating a data set (ΔT). In each example described herein the spectral performance and numeric values measured for each layer were compared to that of the design file to determine conformance or non-conformance with the design file. In this example, the mean chroma was 6.8 ± 3 at an angle of incidence of 15 degrees. The mean reflection factor, Rm, on the rear face or concave face of the lens, between 400 and 700 nm, was 9.46% ± 3%. The mean light reflection factor, Rv, on the rear face or concave face of the lens in the visible region Rv was 9.13% ± 3%. As indicated by the asterisk, the hue angle (h), Rm (400-700 nm), and Rv (380-780 nm) of the applied layers HI-1, LI-1, and HI-2 did not conform to the values associated with the programmed physical thickness value T or any of the parameters associated with the design file, such as, for example, spectral performance.

### Example 4

Referring to FIG. 6, a graph of the spectral performance (i.e., a plot of the % reflectance against various wavelengths) after the deposition of a single raw material layer onto at least one substrate is illustrated, using the methods and systems described above. Below in Table 1 is data corresponding to the spectral performance of FIG. 6.

**Table 4**

| Identification Face | h(°) (hue angle h) | C* (chroma) | Rm (%) (400-700 nm) (mean reflection factor) | Rv (%) (380-780 nm) (Visible light reflectance) |
|---|---|---|---|---|
| Cc IN ORMA | 326* | 8.6 | 10.02* | 8.66* |
| Cc EX ORMA | 326* | 8.7 | 10.03* | 8.67* |
| Mean | 326 | 8.6 | 10.03 | 8.67 |

Table 4 describes the hue, chroma, Rm% (400-700 nm), and Rv% (380-780 nm) after the deposition of at least one high index layer HI-1 + a low index layer LI-1 + a high index layer HI-2 + another LI-2 layer of a raw material, onto at least one substrate, where the substrate is a lens. More particularly, the lens substrate is an ORMA lens. The layers HI-1, LI-1, HI-2, and LI-2 were deposited onto at least a portion of the identification face or concave (Cc) surface of the lens. In this example two lenses were positioned within a vacuum deposition chamber, one lens in an interior (IN) position and another lens in an exterior (EX) position. This positioning of each lens substrate allowed the first layer HI-1, followed by the second through fourth layers LI-1, HI-2, and LI-2, to be deposited in a substantially even distribution across the concave surfaces of each of the lenses to form applied layers HI-1, LI-1, HI-2, and LI-2.

The layers HI-1, LI-1, HI-2, and LI-2 were deposited onto at least a portion of the concave surface of each of the lenses such that the cumulative mean hue angle (h) of the applied layers HI-1, LI-1, HI-2, and LI-2 was 326 ± 3. After the spectral performance of the applied layers HI-1, LI-1, HI-2, and LI-2 was measured using a spectrophotometer, the programmed physical thickness (T) of the at least one applied layers HI-1, LI-1, HI-2, and LI-2 was compared to the optical thickness of the applied layers, thereby generating a data set (AT).

In each example described herein the spectral performance and numeric values measured for each layer were compared to that of the design file to determine conformance or non-conformance with the design file. In this example, the mean chroma was 8.6 ± 3% at an angle of incidence of 15 degrees. The mean reflection factor, Rm, on the rear face or concave face of the lens, between 400 and 700 nm, was 10.03% ± 3%. The mean light reflection factor, Rv, on the rear face or concave face of the lens in the visible region Rv was 8.67% ± 3%. As indicated by the asterisk, the hue angle (h), Rm (400-700 nm), and Rv (380-780 nm) of each of the applied layers HI-1, LI-1, HI-2, and LI-2 did not conform to the values associated with the programmed physical thickness value T or any of the parameters associated with the design file, such as, for example, spectral performance.

The method described herein can further comprise adjusting the programmed physical thickness (T) of the applied layer and further depositing at least one layer n, where n is an integer equal to or greater than 1. This deposition process can be repeated for each layer of material "n" that is deposited onto the at least one substrate.

### Example 5

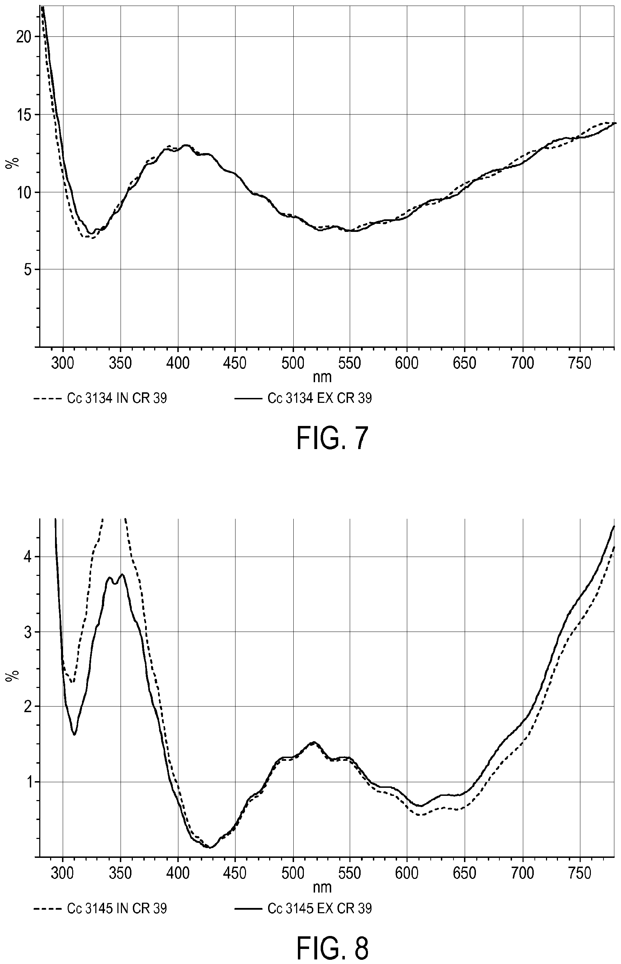

Referring to FIG. 7, a graph of the spectral performance (i.e., a plot of the % reflectance against various wavelengths) after the deposition of a single raw material layer onto at least one substrate is illustrated, using the methods and systems described above. Below in Table 1 is data corresponding to the spectral performance of FIG. 7.

**Table 5**

| Identification Face | h(°) (hue angle h) | C* (chroma) | Rm (%) (400-700 nm) (mean reflection factor) | Rv (%) (380-780 nm) (Visible light reflectance) |
|---|---|---|---|---|
| Cc ORMA (IN) | 308* | 10.3 | 9.75* | 8.22* |
| Cc ORMA (EX) | 308* | 10.4 | 9.70* | 8.17* |
| Mean | 308 | 10.3 | 9.72 | 8.19 |

Table 5 describes hue, chroma, Rm% (400-700 nm), and Rv% (380-780 nm) after the deposition of a high index (HI-1) layer + a low index (LI-1) layer + a high index (HI-2) layer + a low index (LI-2) layer + an antistatic layer such as ITO (indium tin oxide), onto at least one substrate, where the substrate is a lens. More particularly, the lens substrate is an ORMA lens. The layers HI-1, LI-1, HI-2, LI-2, and ITO were deposited onto at least a portion of the identification face or concave (Cc) surface of the lens substrate. In this example, two lenses were positioned within a vacuum deposition chamber, one lens in an interior (IN) position and another lens in an exterior (EX) position. This positioning of each lens substrate allowed the layers HI-1, LI-1, HI-2, LI-2, and ITO to be deposited in a substantially even distribution across the concave surfaces of each of the lenses to form applied layers of HI-1, LI-1, HI-2, LI-2, and ITO.

The layers HI-1, LI-1, HI-2, LI-2, and ITO were deposited onto at least a portion of the concave surface of each of the lenses such that the cumulative mean hue angle (h) of the applied layers was 308 ± 3. After the spectral performance of the layers HI-1, LI-1, HI-2, LI-2, and ITO were measured using a spectrophotometer, the programmed physical thickness (T) of the applied layers HI-1, LI-1, HI-2, LI-2, and ITO were compared to the optical thickness of the applied layer, thereby generating a data set (ΔT).

In each example described herein the spectral performance and numeric values measured for each layer were compared to that of the design file to determine conformance or non-conformance with the design file. In this example the mean chroma was 8.6 ± 3 at an angle of incidence of 15 degrees. The mean reflection factor, Rm, on the rear face or concave face of the lens, between 400 and 700 nm, was 10.03% ± 3%. The mean light reflection factor, Rv, on the rear face or concave face of the lens in the visible region Rv was 8.19% ± 3%. As indicated by the asterisk, the hue angle (h), Rm (400-700 nm), and Rv (380-780 nm) of the applied layers HI-1, LI-1, HI-2, LI-2, and ITO did not conform to the values associated with the programmed physical thickness value (T) or any of the parameters associated with the design file, such as, for example, spectral performance. As each layer of a high index or low index raw material was deposited onto the at least one substrate, each cumulative layer could be compared to the spectral performance data of each layer in the design file to see if the spectral performance matched the design file, as described above.

As described above, for each example the method can further comprise adjusting the programmed physical thickness (T) of the applied layer and further depositing at least one layer n, where n is an integer equal to or greater than 1. This deposition process can be repeated for each layer of material "n" that is deposited onto the at least one substrate.

### Example 6

Referring to FIG. 8, a graph of the spectral performance (i.e., a plot of the % reflectance against various wavelengths) after the deposition of a single raw material layer onto at least one substrate is illustrated, using the methods and systems described above. Below in Table 1 is data corresponding to the spectral performance of FIG. 8.

**Table 6**

| Identification Face | h(°) (hue angle h) | C* (chroma) | Rm (%) (400-700 nm) (mean reflection factor) | Rv (%) (380-780 nm) (Visible light reflectance) |
|---|---|---|---|---|
| Cc IN ORMA | 144 | 12.9 | 0.88 | 1.06 |
| Cc EX ORMA | 138 | 12.3 | 0.96 | 1.12* |
| Mean | 141 | 12.6 | 0.92 | 1.09 |

Table 6 describes the hue, chroma, Rm% (400-700 nm) and Rv% (380-780 nm) after the deposition of a first layer "n" of a raw material onto at least one substrate, where the substrate is a lens. More particularly, the lens substrate is an ORMA lens. The high index layer (HI-1), followed by a second low index layer (LI-1), followed by a third high index (HI-2) layer, a fourth low index (LI-2) layer, an antistatic layer ITO, and a high index (HI-3) layer, for a total of 6 layers, were deposited onto at least a portion of the identification face or concave (Cc) surface of the lens. In this example two lenses were positioned within a vacuum deposition chamber, one lens in an interior (IN) position and another lens in an exterior (EX) position. This positioning of each lens substrate allowed the HI-1 + LI-1 + HI-2 + LI-2 + ITO + HI-3 layers to be deposited in a substantially even distribution across the concave surfaces of each of the lenses to form applied layers of HI-1 + LI-1 + HI-2 + LI-2 + ITO + HI-3 layers.

The HI-1 + LI-1 + HI-2 + LI-2 + ITO + HI-3 layers were deposited onto at least a portion of the concave surface of each of the lenses such that the cumulative mean hue angle (h) of the applied layers HI-1 + LI-1 + HI-2 + LI-2 + ITO + HI-3 layers was 141 ± 3. After the spectral performance of the layers HI-1 + LI-1 + HI-2 + LI-2 + ITO + HI-3 layers was measured using a spectrophotometer, the programmed physical thickness (T) of the applied layers HI-1 + LI-1 + HI-2 + LI-2 + ITO + HI-3 layers was compared to the optical thickness of the applied layers, thereby generating a data set (ΔT).

In each example described herein the spectral performance and numeric values measured for each layer were compared to that of the design file to determine conformance or non-conformance with the design file. In this example the mean chroma was 12.6 ± 3 at an angle of incidence of 15 degrees. The mean reflection factor, Rm, on the rear face or concave face of the lens, between 400 and 700 nm, was 0.92% ± 3%. The mean light reflection factor, Rv, on the rear face or concave face of the lens in the visible region Rv was 1.09% ± 3%. As indicated by the asterisk, the Rv (380-780 nm) of the applied layers HI-1 + LI-1 + HI-2 + LI-2 + ITO + HI-3 layers did not conform to the values associated with the programmed physical thickness value (T) or any of the parameters associated with the design file, such as, for example, spectral performance. As described above, as each layer of an AR stack was deposited onto the at least one substrate, each cumulative layer could be compared to the spectral performance data of each layer in the design file to see if the spectral performance matched the design file.

The method can further comprise adjusting the programmed physical thickness (T) of the applied layer and further depositing at least one layer n, where n is an integer equal to or greater than 1. This deposition process can be repeated for each layer of material "n" that is deposited onto the at least one substrate.

### Example 7

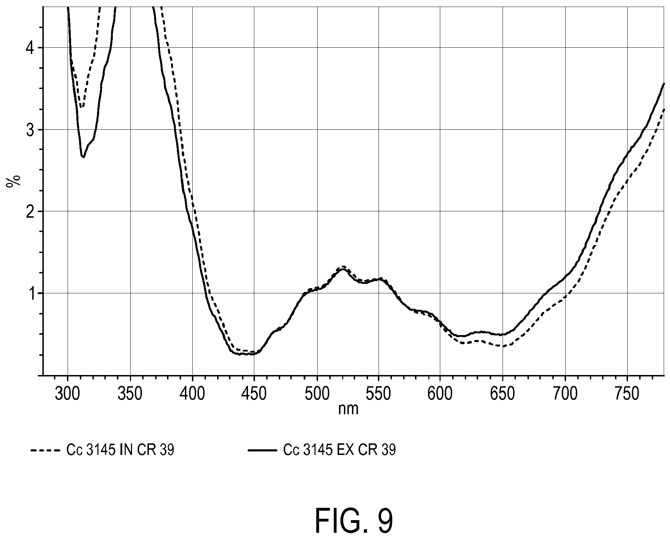

Referring to FIG. 9, a graph of the spectral performance (i.e., a plot of the % reflectance against various wavelengths) after the deposition of a single raw material layer onto at least one substrate is illustrated, using the methods and systems described above. Below in Table 1 is data corresponding to the spectral performance of FIG. 9.

**Table 7**

| Identification Face | h(°) (hue angle h) | C* (chroma) | Rm (%) (400-700 nm) (mean reflection factor) | Rv (%) (380-780 nm) (Visible light reflectance) |
|---|---|---|---|---|
| Cc ORMA (IN) | 146 | 11.1 | 0.77 | 0.93 |
| Cc ORMA (EX) | 141 | 10.9 | 0.79 | 0.94 |
| Mean | 144 | 11.0 | 0.78 | 0.93 |

Table 7 describes the hue, chroma, Rm% (400-700 nm), and Rv% (380-780 nm) after the deposition of raw materials as follows: a first high index (HI-1) layer + a low index (LI-1) layer + a high index (HI-2) layer + a low index (LI-2) layer + ITO + a high index (HI-3) + DSX (an anti-fouling coating), onto at least one substrate, for a total of seven (7) layers, where the substrate is a lens. More particularly, the lens substrate is a ORMA lens. The HI-1 + LI-1 + HI-2 + LI-2 + ITO + HI-3 + DSX layers were deposited onto at least a portion of the identification face or concave (Cc) surface of each lens substrate. In this example at least two lenses were positioned within a vacuum deposition chamber on, one in an interior (IN) position and another lens in an exterior (EX) position. This positioning of the lens substrate allowed the HI-1 + LI-1 + HI-2 + LI-2 + ITO + HI-3 + DSX layers to be deposited in a substantially even distribution across the concave surfaces of each of the lenses to form applied layers of HI-1 + LI-1 + HI-2 + LI-2 + ITO + HI-3 + DSX.

The layers HI-1 + LI-1 + HI-2 + LI-2 + ITO + HI-3 + DSX were deposited onto at least a portion of the concave surface of each of the lenses such that the cumulative mean hue angle (h) of the applied layers was 144 ± 3. After the spectral performance of the applied layers HI-1 + LI-1 + HI-2 + LI-2 + ITO + HI-3 + DSX was measured using a spectrophotometer, the programmed physical thickness (T) of the applied layers HI-1 + LI-1 + HI-2 + LI-2 + ITO + HI-3 + DSX was compared to the optical thickness of the applied layers, thereby generating a data set (ΔT).

In this example, all values tested, i.e., the hue angle (h), the chroma C*, Rm (400-700 nm), and Rv (380-780 nm) conformed to the values associated with the programmed physical thickness value (T) of the design file. Particularly the mean hue angle (h) was 144 ± 3. The mean chroma was 11.0 ± 3% at an angle of incidence of 15 degrees. The mean reflection factor, Rm, on the rear face or concave face of the lens, between 400 and 700 nm, was 0.78% ± 3%. The mean light reflection factor, Rv, on the rear face or concave face of the lens in the visible region Rv, between 380 and 780 nm, was 0.93% ± 3%.

Because all of the above-described values conformed to the programmed values, no further adjustment of the programmed physical thickness (T) of any of the layers or any of the other layers was necessary. The method can further comprise adjusting the programmed physical thickness (T) of the applied layer and further depositing at least one layer n, where n is an integer equal to or greater than 1. This deposition process can be repeated for each layer of material "n" that is deposited onto the at least one substrate.

The methods of coating a substrate and systems described herein provide several benefits. The methods and systems described herein allow a user or manufacturer more control over the composition of deposited layers as well as the ability to measure the spectral performance of each layer after each layer is deposited onto the substrate. This ability to trouble-shoot the spectral performance of each layer in real time during the vacuum deposition process eliminates the need for an operator to repeat the process after having arrived at an incorrect stack, for instance. The described methods and systems disclosed herein provide uniformity and repeatability, thereby ensuring increased consistency and optimization of each thin film as well as the final formed coating and its quality. This also allows the user to better verify the accuracy of each deposited layer onto the at least one substrate.

The particular examples disclosed above are illustrative only, as the present invention may be modified and practiced in different but equivalent manners apparent to those skilled in the art having the benefit of the teachings herein. It is, therefore, evident that the particular illustrative examples disclosed above may be altered or modified and all such variations are considered within the scope of the present invention. The various elements or steps according to the disclosed elements or steps can be combined advantageously or practiced together in various combinations or sub-combinations of elements or sequences of steps to increase the efficiency and benefits that can be obtained from the invention.

It will be appreciated that one or more of the above embodiments may be combined with one or more of the other embodiments, unless explicitly stated otherwise. The invention illustratively disclosed herein suitably may be practiced in the absence of any element or step that is not specifically disclosed or claimed. Furthermore, no limitations are intended to the details of construction, composition, design, or steps herein shown, other than as described in the claims.

## Claims

1. A method of coating at least one substrate with a multi-layered coating, the method comprising:
providing a) at least one test substrate, b) a programmed physical thickness (T) for at least one layer of the multi-layered coating, and c) a design file comprising a target physical thickness and target spectral performance for the at least one layer of the multi-layered coating;
depositing the at least one layer onto the test substrate to form an applied layer having an optical thickness;
measuring a spectral performance of the applied layer; and
comparing the programmed physical thickness (T) to the optical thickness of the applied layer, thereby generating a data set (ΔT).

2. The method of claim 1, wherein the method of depositing further comprises depositing the at least one layer consisting of a high index material or a low index material.

3. The method of claim 1, wherein the method further comprises calculating, using the data set (ΔT), a programmed physical thickness (T') sufficient to achieve the target physical thickness for the at least one applied layer.

4. The method of claim 1, wherein the step of depositing the at least one layer further comprises depositing a layer (n) onto the at least one substrate to form an applied layer, wherein n is an integer equal to or greater than 1.

5. The method of claim 4, wherein the method further comprises measuring a spectral performance of the applied layer.

6. The method of claim 5, wherein the method further comprises comparing the spectral performance of the applied layer to the target spectral performance of the at least one layer.

7. The method of claim 6, wherein the method further comprises adjusting the programmed physical thickness of the applied layer.

8. The method of any of claims 1-4, wherein the step of depositing further comprises depositing at least one raw material selected from the group consisting of: SiO, SiO₂, SnO₂ MgF₂, ZrF₄, AlF₃, CaF₃, CeF₃, GdF₃, LaF₃, LiF, Na₃Al₃F₁₄, Na₃AlF₆, TiO, TiO₂, PrTiO₃, LaTiO₃, ZrO₂, Ta₂O₅, Y₂O₃, Ce₂O₃, La₂O₃, Gd₂O₃, Dy₂O₅, Nd₂O₅, HfO₂, Sc₂O₃, Pr₂O₃, Al₂O₃, Si₃N₄, NdF₃, ITO, Ta₂O₅, Nb₂O₅, YF₃, and mixtures thereof.

9. The method of any of claims 1-8, wherein the method further comprises measuring the spectral performance of the applied layer using a spectrophotometer.

10. The method of any of claims 1-9, wherein the method forms the multi-layered coating on at least one ophthalmic lens substrate.

11. A system for coating at least one substrate with a multi-layered coating, the system comprising:
a vacuum chamber comprising a programmed physical thickness (T);
a design file comprising a target spectral performance for at least one layer of the multi-layered coating; and
at least one apparatus for depositing at least one layer of the multi-layered coating onto the substrate, wherein the apparatus is configured to deposit the at least one layer onto the substrate to form an applied layer having an optical thickness.

12. The system of claim 11, wherein the system further comprises a means for monitoring the conformance of the spectral performance of at least one layer of the multi-layered coating to the target spectral performance of the at least one layer of the multi-layered coating.

13. The system of claim 11, wherein the system further comprises a spectrophotometer.

14. An optical article produced by the method of claims 1 to 10.

15. The optical article of claim 14, wherein the at least one substrate is an ophthalmic lens.
